# EUROPEAN PATENT APPLICATION

(11) **EP 2 511 620 A2**
(43) Date of publication of application: **17.10.2012**
(21) Application number: 12275044.1
(22) Date of filing: 13.04.2012
(51) Int. Cl.: F24F 13/06, F24F 13/14, H05K 7/20

(54) **Air diverter**

(30) Priority: 15.04.2011 GB 201106437
(71) Applicant: 4Energy Limited, Debdale Industrial Estate Keyworth Nottinghamshire NG12 5HN (GB)
(72) Inventor: Redshaw, Stuart Peter, Nottingham, NG12 5HN (GB); Tindale, Patrick, Nottingham, NG12 5HN (GB)
(74) Representative: Clark, David Julian

(57) **Abstract**

The invention relates to air diverters for use in ventilation systems, and in particular to diverters provided with a 'fail-safe' configuration. Embodiments disclosed include an air diverter valve (200) for a ventilation system, the air diverter valve comprising: a frame (201) having first and second openings (202, 203) and a longitudinal axis (204); a shutter (205) mounted to the frame for rotation about the longitudinal axis and having a convex cylindrical outer surface (206), the shutter being rotatable from a first position in which the outer surface covers the first opening to restrict air flow therethrough towards a second position where the first opening is uncovered to allow air flow between the first and second openings; and a rotary actuator (207) configured to rotate the shutter between the first and second positions, wherein the shutter is biased towards the first position such that, in use, de-activation of the actuator causes the shutter to return to, or remain in, the first position.

## Description

The invention relates to air diverters for use in ventilation systems, and in particular to diverters provided with a 'fail-safe' configuration.

Air ventilation systems, such as those used in providing air cooling for data centres, may be typically configured to operate in two basic modes: a recirculation mode and a 'free air' mode. In a recirculation mode, air is recirculated within the environment to be ventilated, and is passed repeatedly through one or more air conditioning units (ACUs) that extract heat from the air. Heat is extracted from the internal environment being ventilated to the external environment by heat exchangers connected to the air conditioning units.

In a 'free air' mode, air from the external environment is used directly to cool the internal environment. This is advantageous when the temperature of the air in the external environment is lower than a temperature set point within the internal environment, such that useful cooling can be achieved either without use of air conditioning or with a reduced air conditioning load.

A combination of recirculation and free air may also be possible, for example to ensure that air within the internal environment is prevented from becoming stale.

In ventilation systems where large-scale cooling is required, such as in data centres, large amounts of air need to be passed through the internal environment. This requires large-scale air handling units and associated valves and actuators. A particular problem with such systems relates to changing between a recirculation mode and a free air mode.

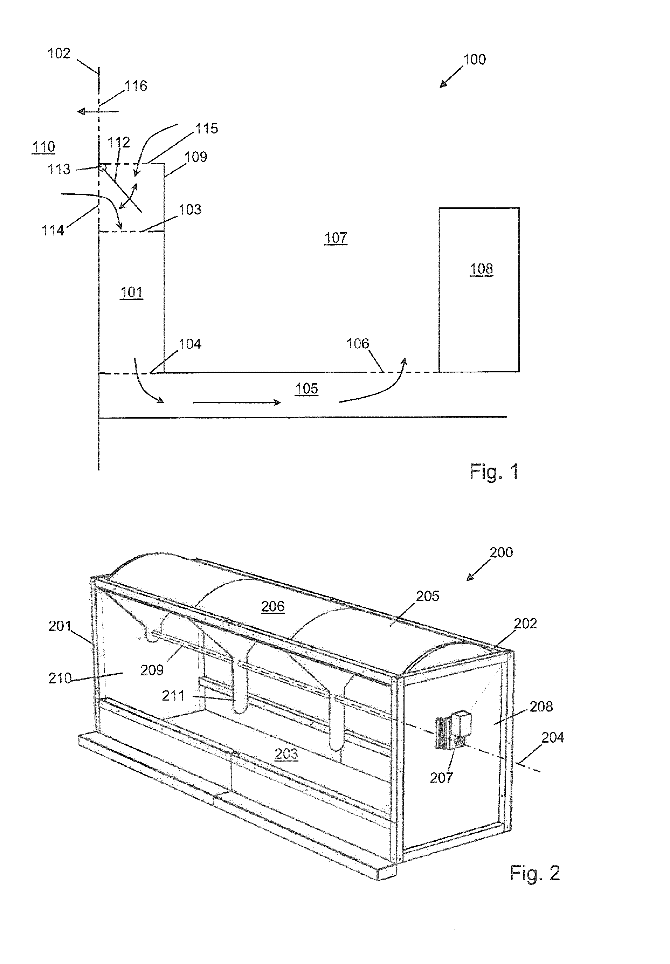

Figure 1 illustrates schematically a partial view of a ventilation system 100 in which an ACU 101 is installed adjacent an external wall 102. The ACU takes in air at an inlet 103 and exhausts air at an outlet 104, which is connected to an underfloor plenum 105. Air flows through the plenum 105 to floor grilles 106 and is distributed around the ventilated room 107 to provide cooling, for example to cool equipment racks 108 within the room. This arrangement is a simplified form of a common data centre arrangement.

Also mounted to the external wall 102 is an air diverter unit 109, which is connected to the inlet 103 of the ACU 101. The air diverter 109 is configured to select whether air is to be passed to the inlet 103 of the ACU from the external environment 110 or from the internal environment within the room 107. In the illustrated embodiment, this is achieved by a rotatable flap 112 that can be rotated about a hinge 113 between a first position in which the flap covers a first inlet 114 of the diverter 109 to prevent air flow entering from the external environment 110 and a second position in which the flap covers a second inlet 115 of the diverter to prevent air flow entering from the internal environment 107. With the flap 112 in the first position, the ventilation system 100 operates in a recirculation mode, where air in the internal environment 107 is continually recirculated through the ACU 101. With the flap 112 in the second position, the ventilation system 100 operates in a 'free air' mode, where air from the external environment 110 flows through the ACU and into the internal environment 107. When in the free air mode, an exhaust 116 will also be required to allow air to exit the internal environment 107. The exhaust 116 will need to be opened at the same time as the flap 112 moves from the second position to the first position, to avoid pressure changes within the internal environment 107 when transitioning between recirculation and free air modes.

The rotatable flap 112 is one way in which such an air diverter unit 109 could work. Other alternatives include louvered vents on the inlets 114, 115 and exhaust 116.

A problem with these types of systems is that the various inlets and outlets need to be controlled and synchronised, which may for example be achieved through the use of multiple actuators or linkages. A further problem is ensuring that the system is able to 'fail safe', for example in the event of a loss of power or a fire alarm. In such events, the ventilation system will typically need to be in a recirculation state to avoid the risk of providing further air that would support a fire within the room.

A further problem relates to the volume of air flow typically required by ventilation systems, especially when large scale cooling is required, such as in data centre applications. High volumetric flows of air will result in pressure being applied to components of the air diverter unit, which may bias the unit towards a particular position. If a fail safe mode is required, such high air flows may prevent the unit from failing in a way that ensures air is recirculated rather than introduced from the external environment.

It is an object of the invention to address one or more of the above mentioned problems.

The listing or discussion of a prior-published document in this specification should not necessarily be taken as an acknowledgement that the document is part of the state of the art or is common general knowledge.

In accordance with the invention there is provided an air diverter valve for a ventilation system, the air diverter valve comprising:
a frame having first and second openings and a longitudinal axis;
a shutter mounted to the frame for rotation about the longitudinal axis and having a convex cylindrical outer surface, the shutter being rotatable from a first position in which the outer surface extends across the first opening to restrict air flow therethrough towards a second position where the first opening is uncovered to allow air flow between the first and second openings; and
a rotary actuator configured to rotate the shutter between the first and second positions,
wherein the shutter is biased towards the first position such that, in use, de-activation of the actuator causes the shutter to return to, or remain in, the first position.

The air diverter valve according to the invention addresses the problem of ensuring the ventilation system fails safely in the event of power loss, as the shutter is biased towards a position that it will remain in or return to, which may for example be a position in which the ventilation system is operating in a recirculation mode. The air diverter also solves the problem of handling high volumetric flows of air, as the shape of the outer surface of the shutter results in pressure being applied orthogonally to the longitudinal axis of the shutter regardless of the position of the shutter. This reduces or eliminates any bias that air flow through the valve may provide, and allows the shutter to remain in or return to the first position even with high volumetric flows of air.

In some embodiments the air diverter may comprise only two openings, for example where the shutter is used to open and close an exhaust outlet for a ventilation system. In other embodiments, the frame may comprise a third opening wherein the outer surface of the shutter extends across the third opening to restrict air flow therethrough when in the second position and to allow air flow between the second and third openings when the shutter is in the first position. The first position may therefore correspond with a free air mode in a ventilation system, with the second position corresponding to a recirculation mode, or *vice versa.*

The shutter may be weighted to return, or remain in, the first position when in use, for example with longitudinal axis oriented horizontally. When used as an exhaust outlet valve, the shutter can be weighted to tend to keep the exhaust outlet closed in the absence of power. When used as a valve to switch between recirculation and free air modes, the shutter can be weighted to tend to keep the air diverter valve in the recirculation mode.

The outer surface of the shutter preferably forms a section of a right circular cylinder. This form allows any air pressure acting on the outer surface to be resolved on the longitudinal axis without tending to move the shutter towards either the first or second position. The shutter is thereby free to move regardless of the volumetric air flow being controlled.

In some embodiments a finer degree of control may be required over air flow when transitioning between the first and second positions. To achieve this, the shutter may comprises an adjustable valve on the outer surface, which can be opened and closed to allow smaller amounts of air flow through the shutter without having to rotate the shutter. Alternatively, or additionally, a leading or trailing edge of the outer surface of the shutter may comprises one or more convolutions extending along the edge, which serve to allow a partial flow of air through the shutter when the shutter is between the first and second positions. An advantage of the edges having convolutions is that air flow past the shutter rises more gradually as the shutter is rotated away from the first or second positions, thereby allowing for a finer control of air flow and reducing sudden disturbances in the air flow, which can cause turbulence.

The air diverter valve may comprise a second shutter mounted to the frame for rotation about the longitudinal axis, the second shutter having a convex cylindrical outer surface and being rotatable from a first position in which the outer surface covers a further opening to restrict air flow therethrough towards a second position where the further opening is uncovered to allow air flow therethrough, the rotary actuator being configured to rotate the first and second shutters between the first and second positions, the first and second shutters being biased towards the first position such that, in use, de-activation of the actuator causes the first and second shutters to return to, or remain in, the first position. An advantage of this arrangement is that a single actuation motion can cause more than one valve action to be achieved. As an example, the first shutter may be used to provide a valve actuation between a free air circulation mode and a recirculation mode, while the second shutter actuates between opening and closing an exhaust synchronously with the first shutter.

For embodiments having more than one shutter, the frame may comprise first and second separable frame portions disposed along adjoining portions of the longitudinal axis, the first shutter being mounted to the first frame portion, the second shutter mounted to the second frame portion, the first and second shutters being connected for synchronised rotation about the common longitudinal axis of the frame. This modular construction allows for larger scale shutters to be constructed from multiple units, which may be identical. The multiple units may be connected so that the shutters in each frame portion all actuate in synchrony with each other. Alternatively, for example in the case where one or more of the shutters forms an exhaust valve, the shutters may be connected to be rotatably offset relative to each other so that each shutter can provide a different valve action.

Aspects and embodiments of the invention are described in further detail below by way of example and with reference to the enclosed drawings in which:
figure 1 is a schematic cross section diagram of a ventilation system;
figure 2 is a perspective view of an exemplary air diverter valve with a shutter in a first position;
figure 3 is a perspective view of the exemplary air diverter valve with the shutter in a second position;
figure 4 is a perspective view of the exemplary air diverter valve with the shutter in an intermediate position;
figure 5 is a perspective view of an alternative exemplary air diverter valve;
figure 6 is a perspective view of a pair of alternative exemplary air diverter valves in a modular configuration;
figure 7 is a perspective view of a further alternative exemplary air diverter valve having an integrated filter;
figures 8a and 8b are schematic partial perspective views of a further alternative exemplary air diverter valve having a shutter with vanes for reducing turbulence;
figure 9 is a schematic partial perspective view of a further alternative exemplary air diverter valve having a shutter with convolutions along leading and trailing edges of the shutter outer surface; and
figure 10 shows various schematic views of a sealing element for providing a seal between the outer surface of the shutter and the frame.

Figure 1 has been discussed above in relation to the background to the invention.

An exemplary air diverter valve 200 for a ventilation system is illustrated in figure 2. The valve 200 comprises a frame 201 having first and second openings 202, 203 and a longitudinal axis 204. A shutter 205 is mounted to the frame 201 for rotation about the longitudinal axis 204. The shutter 205 is shown in figure 2 in a first position in which an outer surface 206 of the shutter 205 covers the first opening 202 of the frame to restrict air flow therethrough. The outer surface 206 of the shutter 205 is in the form of a section of a right circular cylinder.

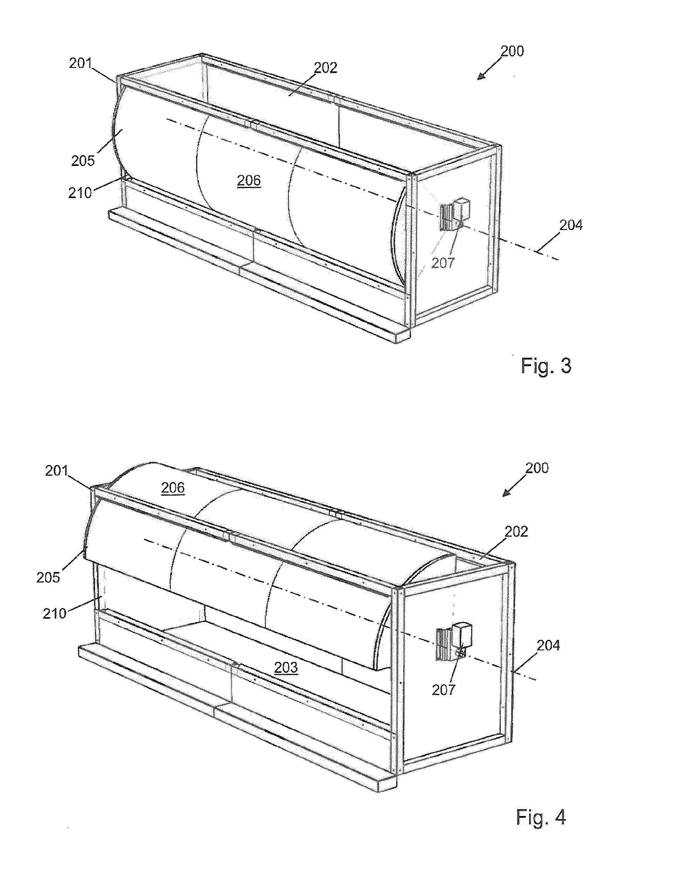

The air diverter valve 200 comprises a rotary actuator 207 in the form of a motor mounted to an end face 208 of the frame. The motor 207 is connected to a shaft 209 on which the shutter 205 is mounted. The motor is operable to rotate the shutter 205 from the first position shown in figure 2 to a second position shown in figure 3, in which the shutter 205 covers the third opening 210 in the frame 201 and the first opening 202 is uncovered to allow air to flow from the first opening to the second opening 203 (figure 2). Movement of the shutter between the first and second positions allow air flow to be controlled between the first and second openings 202, 203 and the third opening 210. In the first position shown in figure 2, air can flow freely between the second and third openings 203, 210, whereas in the second position shown in figure 3, air can flow freely between the first and third openings 202, 210.

With the shutter 205 is rotated between the first and second positions, as shown in figure 4, a portion of air flow is permitted through both of the first and third openings 202, 210. This intermediate position may be used for example when allowing a portion of external air to enter a ventilation system while the system is being used in a partial recirculation mode. This can be useful for example where an amount of external air is required to prevent air within the system from becoming stale.

The shutter 205 comprises a biasing mechanism to cause the shutter to return to, or remain in, the first position indicated in figure 2. The biasing mechanism may be in the form of a counterweight 211 (figure 2) configured to cause the shutter to return to the first position when no rotational force is applied to the shutter about the longitudinal axis 204. The counterweight 211 is preferably sufficient to overcome any frictional resistance and any resistance provided by the motor 207 when inactive. The biasing mechanism may alternatively be provided by a spring mechanism configured to return the shutter to the first position, although a disadvantage of this is the need for a back stop to fix the shutter in the first position against a returning force of the spring. In either case, a damper mechanism may be used to control the speed at which the shutter returns to the first position. The biasing mechanism that causes the shutter 205 to return to, or remain in, the first position is preferably configured to operate with the longitudinal axis 204 oriented horizontally, as shown in figure 2. Other orientations may however be used, for example where the longitudinal axis is oriented vertically or at an angle to the horizontal, in which case the biasing mechanism may also be a spring or counterweight arrangement that causes the shutter to rotate back to the first position. A counterweight in such cases may for example be configured to apply a rotational returning force to the shutter by means of a pulley arrangement. A spring biasing mechanism may in each case be in the form of a torsion spring arranged about the longitudinal axis 204.

The motor 207 used to drive the shutter 205 may for example be a servomotor, which is relatively freely rotatable when inactive and can be controlled to rotate to a specified position on command. The motor 207 may be geared to provide an increased level of torque, although at a reduced speed and requiring a larger biasing force to overcome resistance when unpowered.

The outer surface 206 of the shutter 205 subtends an angle around the longitudinal axis of the air diverter valve frame 201. The subtended angle may typically be around 90 degrees, although could be greater than this, for example between 90 and 180 degrees, depending on the area of the openings to be covered and uncovered. The angle may be less than 90 degrees if the thickness of the frame 201 is greater or if the openings are not required to be completely covered in use. In preferred embodiments, the outer surface 206 of the shutter seals against at least a pair of longitudinal edges of the frame when the shutter is in the first position, and preferably also when the shutter is in the second position. A seal may be provided by brush seals or resilient seals.

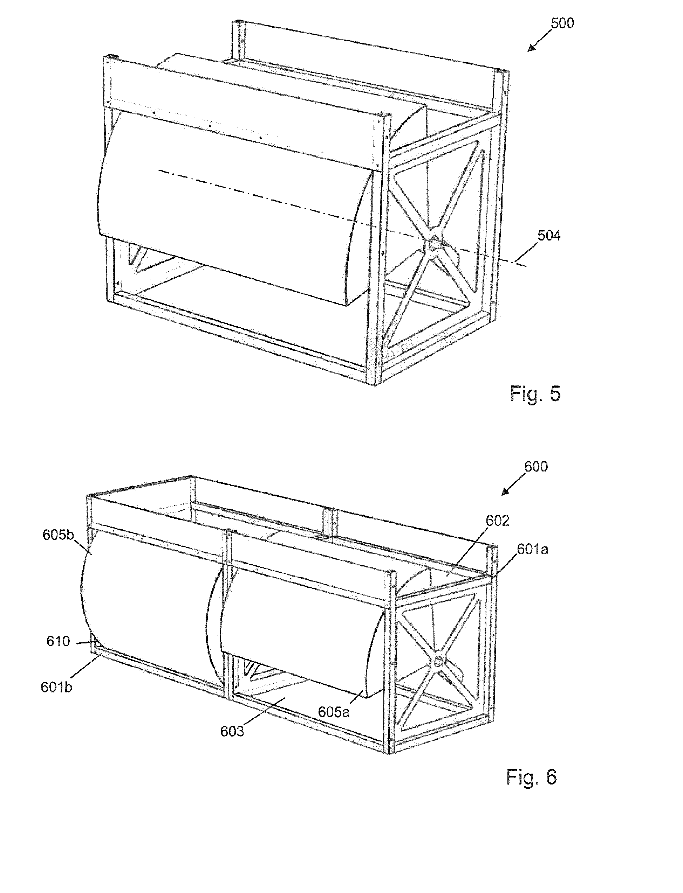

An alternative exemplary air diverter valve 500 is illustrated in figure 5. This valve 500 is essentially similar to the valve 200 of figures 2-4 but is shorter in length, i.e. in the direction along the longitudinal axis 504. The valve 500 can be used in conjunction with other similar or identical valves as part of a modular air diverter valve construction, an example of which is illustrated in figure 6. The modular air diverter valve 600 has a frame comprising a first frame portion 601 a and a second frame portion 601 b, a first shutter 605a mounted to the first frame portion 601 a and a second shutter 605b mounted to the second frame portion 601 b. Other components of the frame portions 601 a,b and shutters 605a,b are similar to those of the previously described valves in figures 2 to 4. First and second openings 602, 603 are provided in the first frame portion 601 a, and a further opening 610 is provided in the second frame portion 601 b, which the outer surface 606b of the second shutter 605b covers when the valve 600 is in the first position. The first and second shutters 605a,b are connected such that they rotate in synchrony with each other, and may be mounted on a common shaft extending along the first and second frame portions 601a,b. The shutter portions 605a,b may alternatively be mounted separately and connected to each other by means of an interlocking mechanism, for example by a connecting plate having interlocking teeth.

In the modular construction shown in figure 6, the shutters are mounted such that their rotational positions are offset relative to each other. This is advantageous when the valve 600 is used to control multiple air flows in one movement, for example where an exhaust opening (which may be the further opening 610) is uncovered at the same time as the first shutter 605a moves from the first position to the second position. The biasing mechanism for the air diverter valve may be adjusted accordingly, so that the shutters return, or remain in, the first position. If using counterweights, the counterweight on the second shutter 605b may be rotated relative to that of the first shutter 605a.

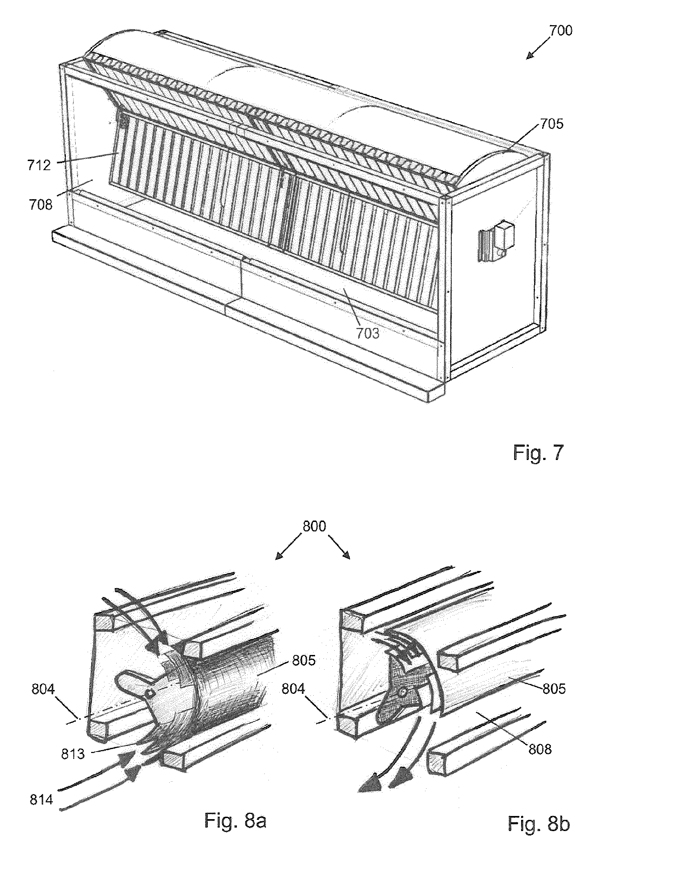

A further alternative embodiment of an air diverter valve 700 is illustrated in figure 7. The valve 700 is a variation on the valve 200 of figure 2, and has corresponding features. In addition, the valve comprises a filter 712 integrated into the shutter 705. In the position shown, a portion of the air passing from the second opening 703 towards the third opening 708 is filtered by passing through the filter 712. An advantage of this arrangement is that of a substantial saving of space, as additional filter units may not be required. A further advantage is that the same filter can be used for filtering air flows with the shutter 705 in the first or second position, provided the direction of air flow through the filter 712 is the same in each position.

For an air diverter valve according to the embodiments disclosed herein to work as part of a ventilation system having high volumetric air flows, the overall dimensions of the diverter valve will typically be of the order of metres in size. The openings in the frame of a typical air diverter valve will be preferably in excess of 1 m², and may be more than 2 m². At this size, frictional resistance resulting from bearings and seals used in the valve can be overcome using the weight of the shutter, including any counterweights added to cause the shutter to return or remain in the first position. For smaller scale applications, where weight may be insufficient to overcome such frictional forces, or alternatively may be too bulky, a spring biasing mechanism may be more preferable.

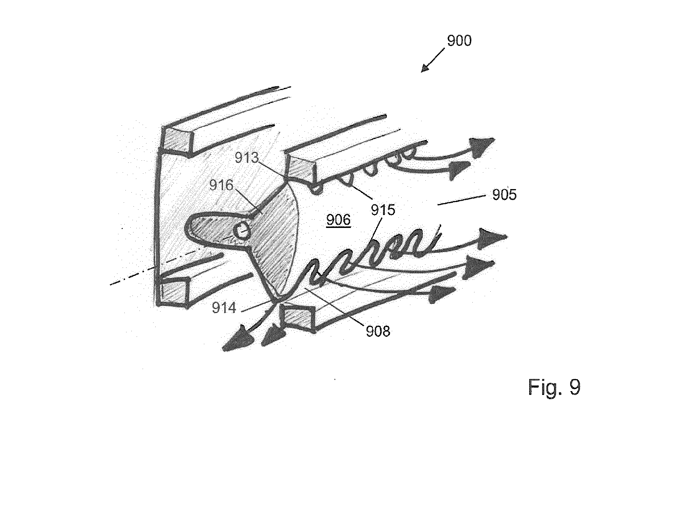

In some applications, air turbulence may be a problem, particularly when transitioning the valve between different positions to change the air flow in a ventilation system. Turbulence within the air diverter valve may be caused by sudden changes in the direction of air flow, which can cause unwanted vibration or a reduction in efficiency of operation. To reduce this effect, various modifications may be made to the shutter, some of which are illustrated in figures 8 and 9. In the alternative embodiments of an air diverter valve 800 illustrated in figures 8a and 8b, the shutter 805 comprises one or more vanes 813 aligned parallel to the outer surface 806 of the shutter 805 around the longitudinal axis 804 of the frame. The vanes 813 are configured to direct air flow 814 in a circular direction around the longitudinal axis 804 of the frame 801. As the shutter is rotated from a first position in figure 8a towards a second position in figure 8b, the vanes 813 maintain this air flow and reduce turbulence caused by the introduction of air through the opening 808.

In a further alternative embodiment of air diverter valve 900, illustrated in figure 9, leading and trailing edges 913, 914 of the outer surface 906 of the shutter 905 of the air diverter valve 900 comprise convolutions or castellations 915 extending across the edges 913, 914. The convolutions 915, comprising a plurality of cut out regions extending across the edges 913, 914, allow air through the opening 908 to 'bleed' through into the valve. This may for example be applied when the valve is in a position corresponding to a recirculation mode, with a small amount of air being allowed into the system to prevent air from becoming stale. A further advantage of the use of such convoluted or castellated edges is that of a finer degree of control over air flow when the shutter is moved partway between the first and second positions, as a more gradual increase in air flow is permitted.

As an alternative or addition to the convolutions or castellations, one or more holes may be provided in an end face 916 of the shutter 905, the holes being aligned with corresponding holes in the an end face of the frame 901. Rotation of the shutter 905 causes the holes to align and allow a portion of air to pass through the valve, allowing a further degree of fine control over air flow, for example to allow a proportion of external air to bleed into the ventilation system.

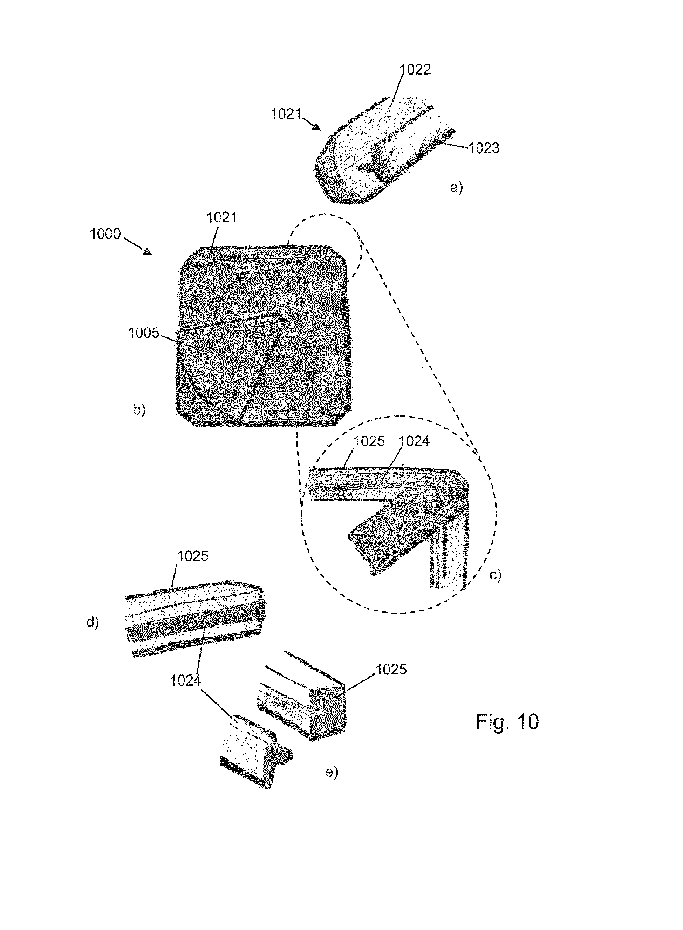

In large scale air flow applications, an air-tight seal between the outer surface of the shutter and the frame may not be required, as any leakages will tend to be small compared with the bulk air flow through the valve. However, to reduce such leakages, seals may be provided along internal edges of the frame to contact the outer surface of the shutter and provide a more air tight seal. Such seals may for example be in the form of brushes, or may be in the form of resilient seals as illustrated in figure 10. Figure 10a shows an edge sealing element 1021 comprising an edge seal support 1022 and a resilient seal 1023 configured to be held within the edge support 1022. Figure 10b shows a cross section of an air diverter valve 1000 with edge sealing elements 1021 forming each longitudinal edge of the frame 1001, i.e. the edges of the frame parallel with the longitudinal axis. Figure 10c shows a magnified view of one of the edges of the frame, with sealing elements 1024 also provided along lateral edges 1025 of the frame, the sealing elements 1024 having a similar construction to the sealing elements 1021 along the longitudinal edges. The sealing elements 1021, 1024 are preferably composed of a resilient deformable material such as rubber or an elastomer to allow for an interference fit with the shutter 1005.

Other embodiments are intentionally within the scope of the invention as defined by the appended claims.

## Claims

1. An air diverter valve for a ventilation system, the air diverter valve comprising:
a frame having first and second openings and a longitudinal axis;
a shutter mounted to the frame for rotation about the longitudinal axis and having a convex cylindrical outer surface, the shutter being rotatable from a first position in which the outer surface covers the first opening to restrict air flow therethrough towards a second position where the first opening is uncovered to allow air flow between the first and second openings; and
a rotary actuator configured to rotate the shutter between the first and second positions,
wherein the shutter is biased towards the first position such that, in use, de-activation of the actuator causes the shutter to return to, or remain in, the first position.

2. The air diverter valve of claim 1 wherein the frame comprises a third opening wherein the outer surface of the shutter covers the third opening to restrict air flow therethrough when in the second position and to allow air flow between the first and third openings when the shutter is in the first position.

3. The air diverter valve of claim 1 or claim 2 wherein the shutter is weighted to return, or remain in, the first position when in use.

4. The air diverter valve of claim 3 wherein the shutter is weighted to to return, or remain in, the first position with longitudinal axis oriented horizontally.

5. The air diverter valve of any preceding claim wherein the outer surface forms a section of a right circular cylinder.

6. The air diverter valve of any preceding claim wherein the shutter comprises an adjustable valve on the outer surface.

7. The air diverter valve of any preceding claim wherein a leading or trailing edge of the outer surface of the shutter comprises one or more convolutions or castellations.

8. The air diverter valve of any preceding claim wherein the shutter comprises one or more vanes aligned parallel to the outer surface of the shutter around the longitudinal axis of the frame.

9. The air diverter valve of any preceding claim wherein the shutter is a first shutter, the air diverter valve comprising a second shutter mounted to the frame for rotation about the longitudinal axis, the second shutter having a convex cylindrical outer surface and being rotatable from a first position in which the outer surface covers a further opening to restrict air flow therethrough towards a second position where the further opening is uncovered to allow air flow therethrough.

10. The air diverter valve of claim 9 wherein the frame comprises first and second separable frame portions disposed along adjoining portions of the longitudinal axis, the first shutter mounted to the first frame portion, the second shutter mounted to the second frame portion, the first and second shutters being connected for synchronised rotation about the longitudinal axis of the frame.

11. A ventilation system comprising the air diverter valve according to any one of claims 1 to 10.
